# EUROPEAN PATENT SPECIFICATION

(11) **EP 0 459 665 B1**
(45) Date of publication and mention of the grant of the patent: **07.12.1994**
(21) Application number: 91304414.5
(22) Date of filing: 16.05.1991
(51) Int. Cl.: H05K 3/46

(54) **Manufacturing method for a multilayer wiring board**
Verfahren zur Herstellung von gedruckten Mehrschicht-Leiterplatten
Procédé de fabrication d'un circuit imprimé multicouche

(30) Priority: 28.05.1990 JP 135505/90
(43) Date of publication of application: 04.12.1991
(73) Proprietor: International Business Machines Corporation, Armonk, N.Y. 10504 (US)
(72) Inventor: Murakami, Takahiro, Kusatsu-shi, Shiga-ken (JP)
(74) Representative: Burt, Roger James, Dr.

(56) References cited:
- EP-A- 0 246 447
- US-A- 3 496 072
- US-A- 4 659 587
- US-A- 4 673 773
- US-A- 4 920 639

## Description

This invention relates to a method of manufacturing a multilayer wiring board, and more particularly to a method of forming an interlayer connection in such a multilayer wiring board. The method is useful in a variety of technical areas, for example in the manufacture of multilayer printed circuit boards for use in computers that require high density packaging.

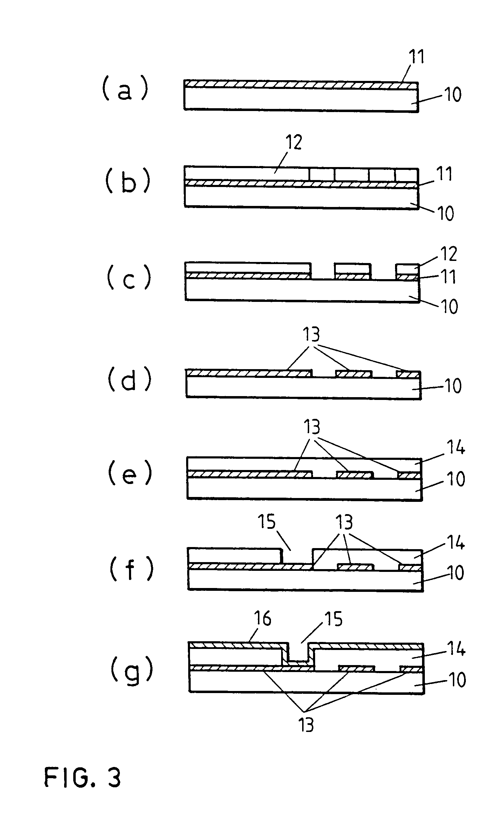

There exist several techniques for forming an interlayer connection during manufacture of thin film multilayer wiring on an organic substrate composed of materials such as epoxy resin. Two such techniques are the insulation layer etching method and the plating pillar method. The steps involved in the insulation layer etching method are shown in Figure 3 (a) to (g). In this method a conductor layer 11 is formed on a substrate 10 having an insulation layer (Figure 3 (a)). Then, photoresist 12 is blanket applied onto the conductor 11, and selectively exposed and developed (Figure 3 (b)). Next the conductor 11 is selectively etched to form a lower layer wiring circuit 13 on desired portions of the substrate Figure 3 (c)), and remaining photoresist 12 is removed (Figure 3 (d)). A insulation layer 14 comprising photosensitive resin is then deposited on the lower layer wiring circuit 13 (Figure 3 (e)), and a via 15 is formed by etching (dry etching or wet etching), or pattern exposure and development, in order to expose an area of the lower layer wiring circuit 13 (Figure 3 (f)). Then, by means of a film forming technique, such as electroless plating, evaporation, or sputtering, a upper layer wiring circuit 16 is deposited on the insulation layer 14, in the via 15, and on the exposed area of the lower layer wiring circuit 13 (Figure (g)). Multi-layer wiring can be formed on the organic substrate through repeated formation of the insulation and the wiring layers.

PUPA (Published Unexamined Patent Application) JP-A- 51 118390 describes a process in which a polyimide film is formed on the surface of a wiring substrate with Al wiring conductor disposed on it. Then an organic Al compound layer is formed on the surface of the polyimide film, parts of the Al compound layer are selectively removed from the polyimide film so as to form through holes therein, and a second conductor layer of Al is formed in the through-holes to form a predetermined multi wiring structure.

JP-A- 58-93298 describes a lower layer wiring pattern that is produced by forming a wiring conductor layer on a substrate, and then forming a resist layer thereon. Next the resist layer is partly removed to form through-holes and an interlayer insulation film constituting multi-layer wiring is formed by using a polyimide based resin. A resist film is then formed on the insulation layer, connecting through-holes are formed by partly removing the resist film, the insulation layer is baked and upper layer wiring is formed on the resulting insulation layer.

JP-A- 60-180197 describes multilayer wiring patterns that are produced by forming a first layer wiring pattern on an insulation substrate, forming a photopolymer film on the first layer and exposing, photo setting and developing the photopolymer film to form a photo-set film with via holes formed at predetermined positions. Then, by use of the photo-set film of the above photopolymer as an inter-layer insulation film, a second layer wiring pattern is formed on the inter layer insulation film and via-holes. The photopolymer film forming processes and wiring pattern forming processes can be repeated in turn to form a multi-layer wiring pattern.

In JP-A- No. 61-121393 and JP-A- 61-127196, a method is described which uses the above insulation layer etching method to form wiring patterns of materials such as copper or chromium on the surface of an insulation layer by plating, sputtering, or evaporation and, at the same time, makes the via hole portions conductive in order to electrically connect with a lower layer conductor pattern.

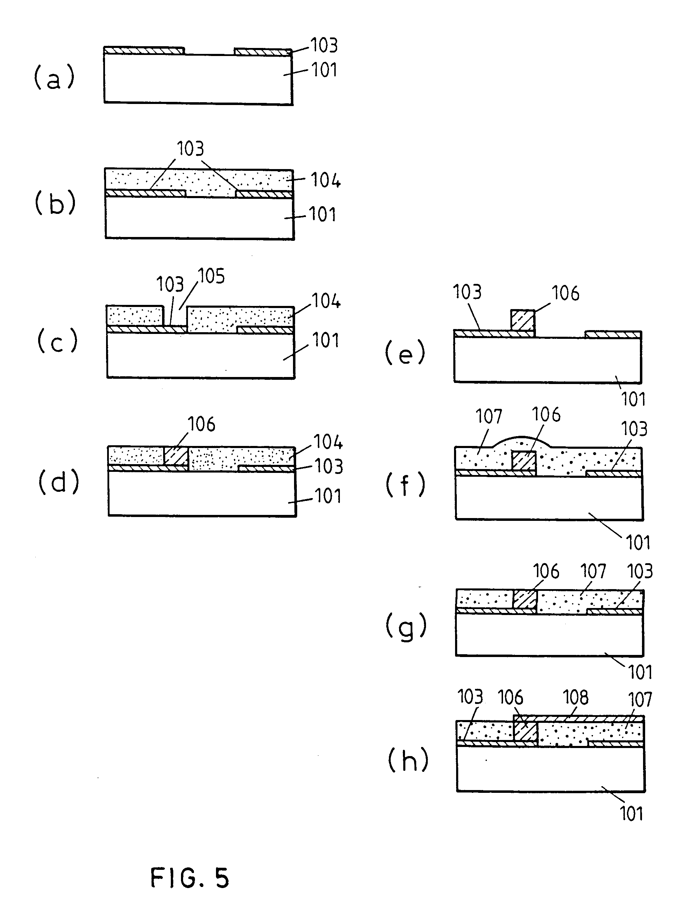

The steps involved in the plating pillar method are shown in Figure 5 (a) to (h). In this method, a metal film for lower layer wiring circuit 103 is deposited on a substrate 101 blanket coated with polyimide resin using film forming techniques such as sputtering. A lower layer wiring circuit 103 is formed by photosensitive resist coating, pattern exposure, developing, resist removing, and etching (Figure 5 (a)).

Then photosensitive resist 104 is blanket coated on the lower layer wiring circuit 103 (Figure 5 (b)), and selectively removed after pattern exposure and development to form a resist hole 105 (Figure 5(c)). A plating pillar 106 is formed in true resist hole 105 by, for example, electroplating (Figure 5 (d)), and then the resist 104 is removed by use of predetermined solvent (Figure 5 (e)). Next, polyimide 107 is applied thereon (Figure 5 (f)), and the surface of the polyimide is smoothed by polishing to expose the top of the plating pillar 106 (Figure 5 (g)). The an upper layer wiring circuit 108 is formed thereon by a film forming technique such as sputtering (Figure 5 (h)). Multi layer wiring can be formed by repetition of these processes.

JP-A- 61 90496 describes a process in which a metal foil for a conductive circuit is deposited on an insulation substrate and lower layer wiring is formed by photoresist coating, pattern exposure, development, plating, resist removal, and etching. Then, a polyimide film is formed on the lower layer wiring and a through-hole is formed by mechanical drilling or a laser in the position desired to be conductive. Next, a plating pillar is formed in the trough-hole by locally supplying plating solution and a laser beam.

JP-A- 63-43396 describes a process multi-layer wiring is produced by forming a lower layer of wiring on the entire surface of a multi-layer wiring alumina substrate, and, after a positive type dry film is pressure bonded, a resist pattern is formed through exposure and development. Next a plating pillar is produced in the formed via hole by electroplating, and the plating resist pattern is removed by solvent. An insulation layer is applied thereon, the surface of the insulation layer is ground to expose the top of the plating pillar, another insulation layer is applied thereon, a resist hole of a desired diameter is formed in this insulation layer, copper is sputter coated in the resist hole and on the surface of the above insulation layer, and the necessary circuit pattern is formed by etching to obtain multi-layer wiring.

JP-A- 63-244797 describes a process in which a positive-type dry film is laminated onto an aluminum substrate (which has a lower-layer wiring pattern formed thereon) to form a resist pattern. Resist holes are formed by exposure and development and then the resist holes are plated with copper sulphate to form a plating pillar, before removing the remaining resist with acetone. The pillar is then coated with a polyimide insulation layer, the surface of the insulation layer is polished to expose the head of the pillar, and a copper layer is deposited on the surface of the insulation layer and the head of the plating pillar with sputtering apparatus to form a desired wiring pattern.

JP-A- 61-179598 describes a process in which a wiring pattern of copper is formed on a ceramic substrate a lower layer of wiring and then a photoresist pattern is formed thereon by use of ordinary photolithographic technique. Next, the lower wiring layer surface exposed through a photoresist hole is electroplated to form a plating pillar. The entire exposed surface of the above plating pillar and the substrate is coated with polyimide resin, and a specified pressure is applied from the surface of the insulation layer toward the substrate in order to make the insulation layer surface layer. Then an upper wiring layer is deposited in a specified position on the insulation layer surface to form wiring.

JP-A- 62-263645 describes a process in which a chrome layer and a copper layer, having been blanket-coated in turn on a substrate, are etched to form a predetermined pattern. Then a positive photoresist is blanket- applied onto the copper layer, and an opening (via hole) is formed by exposure and development of the resist. The positive photoresist is silicated, a plating pillar is formed in the opening by dipping the opening in a molten solder bath the silicated resist remaining as a solder barrier, and upper-layer wiring is connected to the pillar.

JP-A- 50-2059 describes a process in which an insulating substrate such as ceramic is coated with a copper layer as a lower-layer wiring, a photoresist film is deposited thereon, and a resist hole is formed by exposing the photoresist to light and then developing it. A conductive material (plating pillar) such as copper is deposited in the hole by electro plating, the residual photoresist is then removed and an insulating material such as epoxy resin is deposited. Next a copper layer is electroless plated on the conductive and insulating materials in order to effect interlayer connection.

To electrically connect a first electric circuit wiring and a second electric circuit wiring, alignment between the first electric circuit and the conductive connecting pillar must be accurate. In the above insulation layer patterning methods there exists a pattern aligning error between the first electric circuit and the pillar and hence the pillar diameter must be enlarged in accordance with the possible error, or, as shown in Figure 4, the size of the first electric circuit 13 must be larger then the diameter of resist hole 15 or conductive pillar 106, and, thus, the electric circuit formation density cannot be increased.

The above plating pillar method has drawback in that photosensitive resist is applied to form a circuit pattern, it is exposed, developed and removed, and then an additional process of applying resist and removing it again is be carried out during formation of the resist hole.

It is an object of the invention to make inter-layer connection between layers of a multi-layer substrate possible in high density electric circuits by preventing mismatching in position between the first electric circuit and the conductive pillar. In the proposed technique photoresist is applied once but utilized in two pattern exposure/development processes.

Another object of the invention is to decrease the number of processes in the manufacture of a multilayer wiring board by omitting the additional photosensitive resist removing and applying processes, and instead using the same photoresist during both the formation of the resist hole and the formation of the first electric circuit pattern.

Viewed from a first aspect, a method for manufacturing a multi-layer wiring board is provided in which interlayer connection is made between a first electric circuit and a second electric circuit, both electric circuits being formed on a substrate, comprising the steps of applying a metal layer onto said substrate and a photoresist onto said metal layer and then partially removing said photoresist to produce a resist hole, said method being characterised by the steps of selectively exposing the remaining photoresist in accordance with a desired pattern for said first electric circuit; forming a conductive pillar in said resist hole; removing the exposed remaining photoresist to reveal corresponding regions of said metal layer and etching said regions to partly expose the substrate and to form said first electric circuit; removing all remaining photoresist and applying an insulation layer onto said first electric circuit, the exposed substrate, and said conductive pillar, such that only one end of said conductive pillar remains exposed; and applying a second metal layer onto said insulation layer and the exposed end of said conductive pillar to form said second electric circuit.

Alternatively, the step of selectively exposing the remaining photoresist can be carried out after the step of forming a conductive pillar.

Viewed from a second aspect, a multilayer wiring board is provided which has been produced in accordance with the method of the present invention.

Using the method of the present invention the pillar constituting a connection between the first and second electric circuits is formed before the first electric circuit is formed, and hence there is no possibility of a shift in position between the pillar and the first electric circuit. Furthermore, it is possible to re-use the positive photoresist applied when forming the pillar in order to form the first electric circuit.

The present invention will be described further, by way of example only, with reference to an embodiment thereof as illustrated in the accompanying drawings, in which:
Figure 1 (a) to (h) are process diagrams showing the steps necessary to produce a multilayer wiring board according to the preferred embodiment of the present invention;
Figure 2 is a schematic view showing the overlapping condition of a conductive pillar and lower-layer circuit pattern in accordance with the preferred embodiment;
Figure 3 (a) to (g) are process diagram showing the steps involved in the conventional insulation layer etching method;
Figure 4 is a schematic view showing the overlapping condition of a conventional conductive pillar and lower layer circuit pattern; and
Figure 5 (a) to (h) are process diagrams showing the steps involved in the conventional plating pillar method.

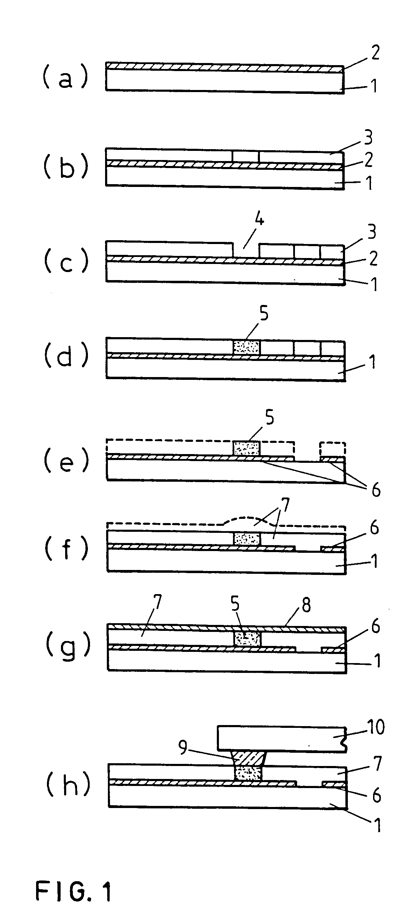

An embodiment of the invention will be explained with reference to Figure 1 (a) to (h).

As shown in Figure 1 (a), a 30µm copper blanket layer 2 is deposited on an organic substrate 1 by use of a known film forming technique such as deposition, sputtering, or electroless plating. Then, a positive resist 3 is applied on the copper layer 2 (Figure 1 (b)). Any photoresist generally available, such as AZ1350J (Sipley Co.), TNS (IBM Corp.), and PMER-P (Tokyooka Ltd.), can be used. It is usually applied by brushing, spin coating, or immersion.

Then, the positive photoresist 3 is exposed through a mask (not shown), the via pattern section of the mask being opaque, and all other sections being transparent (Figure 1 (b)). Then the photoresist is developed, and the resist area corresponding to the area where a conductive connecting pillar is to be formed is removed to produce a resist hole 4. This partially exposes the copper layer 2 where a lower layer wiring assembly is to be formed (Figure 1 (c)).

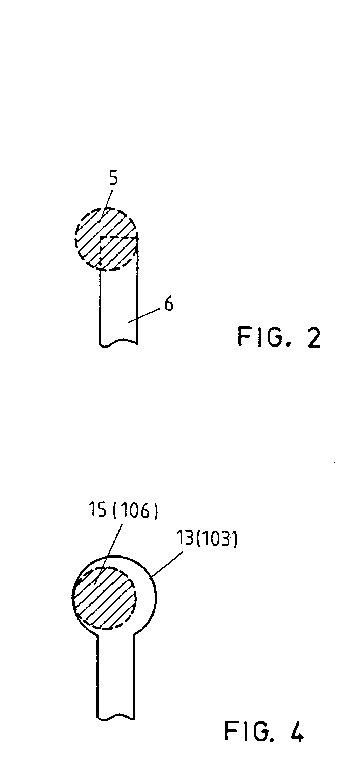

In order to define the lower layer circuit pattern, the residual positive photoresist 3 is again exposed through a mask (not shown), the wiring pattern section of the mask being opaque, and all other sections becoming transparent (Figure 1 (c)). Alternatively, the lower-layer circuit pattern can be defined after the pillar has been formed, by exposing the residual positive photoresist ,as above, but after formation of the pillar. The pillar 5 comprising copper, tin, or solder plating is formed in the resist hole 4 by electro-plating (Figure 1 (d)). When etching the lower-layer wiring assembly comprised of copper as described later, then in order to prevent etching of the copper pillar 5, the copper of the pillar is covered with either tin, solder plating, electrodeposited coat film, or electrodeposited positive photoresist film. When the residual photoresist 3 has been developed with alkaline developing solution such as NaOH and TMAM, the portions of the photoresist exposed in accordance with the lower-layer circuit pattern are removed. This partially exposes the copper layer 2 from which the lower-layer wiring section is to be formed. The exposed portions of the copper layer 2 are etched using a wet etching technique in which the exposed regions are immersed in, for example, a mixed sulphuric acid and hydrogen peroxide etching solution at 50°C for 2 min 30 sec. If the substrate 1 is composed of ceramic, silicon, or glass, then instead of wet etching, dry etching may be employed using a known gas, such as Ar and CF₄, suitable for the material to be etched. The etching process partially exposes the surface of the substrate 1, and hence defines a lower-layer electric circuit 6 (Figure 1(e)). By the above process the pillar 5 and the lower-layer electric circuit 6 are produced in exact alignment with each other as shown in Figure 2. After the lower-layer electric circuit 6 has been formed, the photoresist 3 is removed with solvent.

Next an organic insulation resin 7, such as epoxy resin, polyimide resin, or BT resin (bismaleimide-triazine resin), is blanket applied, dried and set so as to cover the surfaces of the organic substrate 1, pillar 5, and lower layer electric circuit 6 (see Figure 1(f)). Then, the surface of the organic insulation resin 7 is polished with a belt sander (a rotary polishing machine with and paper rolled in belt form) and a brush polishing machine (a polishing machine having a brush with abrasive grain applied to it) to expose head of the via bump 5. An upper electric circuit metal layer 8 comprising copper is then deposited thereon using a known film forming technique such as electro-plating (Figure 1 (g)). Alternatively a thin metal layer can be formed on a substrate such as of ceramic, silicone, or glass, using a film forming technique such as sputtering or evaporation. By the above steps electrical contact is produced between the lower-layer electric circuit 6 and the upper-layer electric circuit 8 via the pillar 5. Multi-layer wiring can be formed by repeating this process. As shown in figure 1(h), instead of forming an upper layer electric circuit metal layer, an upper layer electric circuit can consist of an electronic part 10 connected to the pillar 5 with solder 9. The pillar can be formed solely from copper, or with solder or tin on the cooper, and its thickness can be changed as required. If the pillar 5 is formed with solder plating, the thickness of the pillar can be controlled as required, and an electronic part can be directly mounted on the pillar.

In the preferred embodiment positional shift between the lower-layer electric circuit and the pillar is eliminated. The technique does not require an increase in size of the circuit, and so an electric circuit of higher density can be attained. In addition, by using the same photoresist to form both the pillar and the lower layer circuit pattern, the extra process of applying and removing photoresist for formation of the pillar in the prior art method can be omitted, and hence the number of manufacturing processes can be decreased.

## Claims

1. A method of manufacturing a multilayer wiring board in which interlayer connection is made between a circuit electric circuit and a second electric circuit, both electric circuits being formed on a substrate (1), comprising the steps of applying a metal layer (2) onto said substrate (1) and a photoresist (3) onto said metal layer (2) and then partially removing said photoresist (3) to produce a resist hole (4), said method being characterised by the steps of:
selectively exposing the remaining photoresist in accordance with a desired pattern for said first electric circuit;
forming a conductive pillar (5) in said resist hole (4);
removing the exposed remaining photoresist to reveal corresponding regions of said metal layer (2) and etching said regions to partly expose the substrate (1) and to form said first electric circuit (6);
removing all remaining photoresist and applying an insulation layer (7) onto said first electric circuit (6), the exposed substrate, and said conductive pillar (5), such that only one end of said conductive pillar remains exposed; and
applying a second metal layer (8) onto said insulation layer (7) and the exposed end of said conductive pillar to form said second electric circuit.

2. A method as claimed in Claim 1, comprising steps of:
blanket coating said metal layer (2) onto said substrate (1);
blanket coating said photoresist (3) onto said metal layer(2);
exposing and developing said photoresist (3) to remove a portion of said photoresist thus defining a resist hole (4);
selectively exposing the residual photoresist remaining after the exposure and development step to define a desired circuit pattern in accordance with said first electric circuit;
forming said conductive pillar (5) in said resist hole (4);
developing and removing the exposed residual photoresist;
etching the metal layer exposed by the development of said residual photoresist to form said first electric circuit;
removing said photoresist from on the metal layer constituting said first electric circuit;
blanket coating an organic insulation layer (7) on said first electric circuit (6), the substrate exposed by etching and said conductive pillar (5);
flattening the surface of said organic insulation layer (7) to expose one end of said conductive pillar (5); and
depositing another metal layer (8) or an electronic part (10) on the exposed surface of said organic insulation layer and said conductive pillar to form said second electric circuit.

3. A method as claimed in Claim 1, comprising steps of:
blanket coating said metal layer (2) onto said substrate (1);
blanket coating said photoresist (3) onto said metal layer (2);
exposing and developing said photoresist (3) to remove a portion of said photoresist thus defining a resist hole (4);
forming said conductive pillar (5) in said resist hole (4);
selectively exposing and developing the residual photoresist remaining after the exposure and development step to define a desired circuit pattern in accordance with said first electric circuit;
etching the metal layer exposed by the development of said residual photoresist to form said first electric circuit;
removing said photoresist from on the metal layer constituting said first electric circuit;
blanket coating an organic insulation layer (7) on said first electric circuit (6), the substrate exposed by etching and said conductive pillar (5);
flattening the surface of said insulation layer (7) to expose one end of said conductive pillar (5); and
depositing another metal layer (8) or electronic part (10) on the exposed surface of said organic insulation layer and said conductive pillar to form said second electric circuit.

4. A method as claimed in any preceding Claim, wherein said photoresist (3) is a positive photoresist.

5. A method as claimed in any preceding claim, wherein, if said conductive pillar consists of the same material as said metal layer, a protective film consisting of a different material to that of said metal layer and conductive pillar is formed on the conductive pillar before said metal layer is etched.

6. A method as claimed in any preceding Claim, wherein said metal layer (2) and second metal layer (8) are copper layers.

7. A method as claimed in Claim 5, wherein said metal layer (2) and conductive pillar (5) are made of copper, and said protective film comprises either tin, solder plating, an electrodeposited coat film, or an electrodeposited positive photoresist film.

8. A method as claimed in any preceding claim, wherein said conductive pillar is formed by electro-plating.

## Patentansprüche

1. Eine Methode zur Herstellung einer Mehrschicht-Leiterplatte, bei der eine Zwischenschicht-Verbindung zwischen einer ersten elektrischen Schaltung und einer zweiten elektrischen Schaltung hergestellt wird, wobei beide elektrische Schaltungen auf einem Substrat (1) gebildet werden, die Schritte des Aüftragens einer Metallschicht (2) auf das genannte Substrat (1) und eines Photoresists (3) auf die genannte Metallschicht (2) umfassend, und anschließendes teilweises Entfernen des genannten Photoresists (3), zur Erzeugung eines Resist-Lochs (4), wobei die genannte Methode durch folgende Schritte gekennzeichnet ist:
Selektives Belichten des verbleibenden Photoresists entsprechend einem gewünschten Bild für die genannte erste elektrische Schaltung;
Bilden eines leitenden Pfostens (5) in dem genannten Resist-Loch (4);
Entfernen des belichteten verbleibenden Photoresists zur Aufdeckung entsprechender Bereiche der genannten Metallschicht (2) und Ätzen der genannten Bereiche, um teilweise das Substrat (1) freizulegen und die genannte erste elektrische Schaltung (6) zu bilden;
Entfernen des gesamten verbleibenden Photoresists und Auftragen einer Isolierschicht (7) auf die genannte erste elektrische Schaltung (6), das freigelegte Substrat und den genannten leitenden Pfosten (5), so daß nur ein Ende des genannten leitenden Pfostens frei bleibt; und Auftragen einer zweiten Metallschicht (8) auf die genannte Isolierschicht (7) und das freigelegte Ende des genannten leitenden Pfostens zur Bildung der genannten zweiten elektrischen Schaltung.

2. Eine Methode nach Anspruch 1, folgende Schritte umfassend:
flächendeckende Beschichtung des genannten Substrats (1) mit der genannten Metallschicht (2);
flächendeckende Beschichtung der genannten Metallschicht (2) mit dem genannten Photoresist (3);
Belichten und Entwickeln des genannten Photoresists (3) zur Entfernung eines Teils des genannten Photoresists, wodurch ein Resist-Loch (4) definiert wird;
selektives Belichten des restlichen, nach dem Belichtungs- und Entwicklungsschritt zurückbleibenden Photoresits, um ein gewünschtes Schaltungsbild entsprechend der genannten ersten elektrischen Schaltung zu definieren;
Bilden des genannten leitenden Pfostens (5) in dem genannten Resist-Loch (4);
Entwickeln und Entfernen des belichteten verbleibenden Photoresists;
Ätzen der Metallschicht, die durch die Entwicklung des genannten verbleibenden Photoresists freigelegt wurde, zur Bildung der genannten ersten elektrischen Schaltung;
Abtragen des genannten Photoresists von der Metallschicht, die die erste elektrische Schaltung bildet;
flächendeckende Beschichtung der genannten ersten elektrischen Schaltung (6), dem durch Ätzen freigelegten Substrat und dem genannten leitenden Pfosten (5) mit einer organischen Isolierschicht (7);
Abflachen der Oberfläche der genannten organischen Isolierschicht (7), um ein Ende des genannten leitenden Pfostens (5) freizulegen; und
Abscheiden einer weiteren Metallschicht (8) oder eines elektronischen Teils (10) auf der freigelegten Oberfläche der genannten organischen Isolierschicht und des genannten leitenden Pfostens zur Bildung der genannten zweiten elektrischen Schaltung.

3. Eine Methode nach Anspruch 1, folgende Schritte aufweisend:
flächendeckendes Auftragen der genannten Metallschicht (2) auf das genannte Substrat (1);
flächendeckendes Auftragen des genannten Photoresists (3) auf die genannte Metallschicht (2);
Belichten und Entwickeln des genannten Photoresists (3), zur Entfernung eines Teils des genannten Photoresists, wodurch ein Resist-Loch (4) definiert wird;
Bilden des genannten leitenden Pfostens (5) in dem genannten Resist-Loch (4);
selektives Belichten und Entwickeln des restlichen, nach dem Belichtungs- und Entwicklungsschritt übrigbleibenden Photoresists, um ein gewünschtes Schaltkreisbild für die genannte erste elektrische Schaltung zu definieren;
Ätzen der Metallschicht, die durch die Entwicklung des genannten restlichen Photoresists freigelegt wurde, um die genannte erste elektrische Schaltung zu bilden;
Abtragen des genannten Photoresists von der Metallschicht, die die genannte erste elektrische Schaltung bildet;
flächendeckendes Auftragen einer organischen Isolierschicht (7) auf die genannte erste elektrische Schaltung (6), das durch Ätzen freigelegte Substrat und den genannten leitenden Pfosten (5);
Abflachen der Oberfläche der genannten organischen Isolierschicht (7), um ein Ende des genannten leitenden Pfostens (5) freizulegen; und
Abscheiden einer weiteren Metallschicht (8) oder eines elektronischen Teils (10) auf der freiliegenden Oberfläche der genannten organischen Isolierschicht und des genannten leitenden Pfostens zur Bildung der genannten zweiten elektrischen Schaltung.

4. Eine Methode nach jedem vorangehenden Anspruch, bei der das genannte Photoresist (3) ein positives Photoresist ist.

5. Eine Methode nach jedem vorangehenden Anspruch, bei der, wenn der genannte leitende Pfosten aus demselben Material wie die genannte Metallschicht besteht, ein Schutzfilm, bestehend aus einem anderen Material als das der genannten Metallschicht und des leitenden Pfostens, auf dem leitenden Pfosten gebildet wird, bevor die genannte Metallschicht geätzt wird.

6. Eine Methode nach jedem vorangehenden Anspruch, bei der die genannte Metallschicht (2) und die zweite Metallschicht (8) Kupferschichten sind.

7. Eine Methode nach Anspruch 5, bei der die genannte Metallschicht (2) und der leitende Pfosten (5) aus Kupfer bestehen und der genannte Schutzfilm entweder aus Zinn, Lotplattierung, einem galvanisch abgeschiedenen Film oder einem galvanisch abgeschiedenen positiven Photoresist-Film besteht.

8. Eine Methode nach jedem vorangehenden Anspruch, bei der der genannte leitende Pfosten durch Elektroplattierung gebildet wird.

## Revendications

1. Procédé de fabrication d'un circuit imprimé multicouche dans lequel une connexion inter-couches est réalisée entre un premier circuit électrique et un second circuit électrique, les deux circuits électriques étant formés sur un substrat (1), comprenant les étapes consistant à appliquer une couche métallique (2) sur ledit substrat (1) et un photorésist (3) sur ladite couche métallique (2) puis à enlever partiellement ledit photorésist (3) pour produire un trou de résist (4), ledit procédé étant caractérisé par les étapes consistant à :
exposer sélectivement le reste du photorésist en conformité avec une configuration souhaitée pour ledit premier circuit électrique ;
former un pilier (5) conducteur dans ledit trou de résist (4) ;
enlever le photorésist restant exposé pour révéler des régions correspondantes de ladite couche métallique (2) et graver lesdites régions pour exposer partiellement le substrat (1) et pour former ledit premier circuit électrique (6) ;
enlever tout le photorésist restant et appliquer une couche d'isolation (7) sur ledit premier circuit électrique (6), le substrat exposé, et ledit pilier conducteur (5), de sorte que seule une extrémité dudit pilier conducteur reste exposée ; et
appliquer une seconde couche métallique (8) sur ladite couche d'isolation (7) et sur l'extrémité exposée dudit pilier conducteur pour former ledit second circuit électrique.

2. Procédé selon la revendication 1, comprenant les étapes consistant à :
revêtir ledit substrat (1) avec ladite couche métallique (2) ;
revêtir ladite couche métallique (2) avec ledit photorésist (3) ;
exposer et développer ledit photorésist (3) pour enlever une partie dudit photorésist et définir ainsi un trou de résist (4) ;
exposer sélectivement le photorésist résiduel restant après l'étape d'exposition et de développement pour définir une configuration de circuit souhaitée en conformité avec ledit premier circuit électrique ;
former ledit pilier conducteur (5) dans ledit trou de résist (4) ;
développer et enlever le photorésist exposé résiduel ;
graver la couche métallique exposée par le développement dudit photorésist résiduel pour former ledit premier circuit électrique ;
enlever ledit photorésist de la couche métallique constituant ledit premier circuit électrique ;
revêtir d'une couche d'isolation organique (7) ledit premier circuit électrique (6), le substrat exposé par gravure et ledit pilier conducteur (5) ;
aplanir la surface de ladite couche d'isolation organique (7) pour exposer une extrémité dudit pilier conducteur (5) ; et
déposer une autre couche métallique (8) ou un élément électronique (10) sur la surface exposée de ladite couche d'isolation organique et dudit pilier conducteur pour former ledit second circuit électrique.

3. Procédé selon la revendication 1, comprenant les étapes consistant à :
revêtir ledit substrat (1) de ladite couche métallique (2) ;
revêtir ladite couche métallique (2) avec ledit photorésist (3) ;
exposer et développer ledit photorésist (3) pour enlever une partie dudit photorésist pour définir ainsi un trou de résist (4) ;
former ledit pilier conducteur (5) dans ledit trou de résist (4) ;
exposer et développer sélectivement le photorésist résiduel restant après l'étape d'exposition et de développement pour définir une configuration de circuit souhaitée en conformité avec ledit premier circuit électrique ;
graver la couche métallique exposée par le développement dudit photorésist résiduel pour former ledit premier circuit électrique ;
enlever ledit photorésist de ladite couche métallique constituant ledit premier circuit électrique ;
revêtir ledit premier circuit électrique (6), le substrat exposé par gravure et ledit pilier conducteur (5) d'une couche d'isolation organique (7) ;
aplanir la surface de ladite couche d'isolation organique (7) pour exposer une extrémité dudit pilier conducteur (5) ; et
déposer une autre couche métallique (8) ou un élément électronique (10) sur la surface exposée de ladite couche d'isolation organique et ledit pilier conducteur pour former ledit second circuit électrique.

4. Procédé selon l'une quelconque des revendications précédentes, dans lequel ledit photorésist (3) est un photorésist positif.

5. Procédé selon l'une quelconque des revendications précédentes, dans lequel, si ledit pilier conducteur est réalisé dans le même matériau que ladite couche métallique, un film protecteur en un matériau différent de celui de ladite couche métallique et du pilier conducteur est formé sur ledit pilier conducteur avant la gravure de ladite couche métallique.

6. Procédé selon l'une quelconque des revendications précédentes, dans lequel ladite couche métallique (2) et ladite seconde couche métallique (8) sont des couches de cuivre.

7. Procédé selon la revendication 5, dans lequel ladite couche métallique (2) et le pilier conducteur (5) sont en cuivre, et ledit film protecteur comporte soit de l'étain, un placage de soudure, un film de revêtement déposé par électrolyse, ou un film photorésist positif déposé par électrolyse.

8. Procédé selon l'une quelconque des revendications précédentes, dans lequel ledit pilier conducteur est réalisé par électro-déposition.
